(19) **Europäisches Patentamt** / **European Patent Office** / **Office européen des brevets**

(11) **EP 4 507 120 B1**

(12) **EUROPEAN PATENT SPECIFICATION**

(45) Date of publication and mention of the grant of the patent:
**06.05.2026   Bulletin 2026/19**

(21) Application number: **23203470.2**

(22) Date of filing: **13.10.2023**

(51) International Patent Classification (IPC):
*H01Q 1/22* (2006.01)     *H10W 42/20* (2026.01)
*H10W 44/20* (2026.01)     *H01Q 1/52* (2006.01)
*H01Q 5/42* (2015.01)     *H01Q 21/06* (2006.01)

(52) Cooperative Patent Classification (CPC):
**H01Q 21/065; H01Q 1/2283; H01Q 1/523;
H01Q 1/525; H01Q 1/526; H01Q 5/42;
H10W 42/263; H10W 42/273; H10W 44/20;**
H10W 42/20; H10W 44/206; H10W 44/209;
H10W 44/248

(54) **ANTENNA-IN-PACKAGE CONSTRUCTION WITH FREQUENCY DIVISION DUPLEX TECHNOLOGY**

GEHÄUSEINTERNE ANTENNENKONSTRUKTION MIT FREQUENZDUPLEXTECHNOLOGIE

CONSTRUCTION D'ANTENNE DANS UN BOÎTIER À TECHNOLOGIE DUPLEX À RÉPARTITION EN FRÉQUENCE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **08.08.2023   TW 112129752**
**18.09.2023   US 202318468779**

(43) Date of publication of application:
**12.02.2025   Bulletin 2025/07**

(73) Proprietor: **Industrial Technology Research Institute**
**Chutung, Hsinchu 310401 (TW)**

(72) Inventors:
• **CHIANG, Ching-Wen**
**300 Hsinchu City (TW)**
• **CHEN, Huan-Ta**
**308 Hsinchu County (TW)**
• **HO, Chung-Lien**
**302 Hsinchu County (TW)**
• **CHEN, Chin Pin**
**302 Hsinchu City (TW)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
**TW-U- M 637 071         US-A1- 2020 035 625
US-A1- 2020 185 299      US-B2- 10 505 255
US-B2- 11 217 543**

## Description

## TECHNICAL FIELD

The disclosure relates to an antenna-in-package construction, and in particular, relates to an antenna-in-package construction that includes a transmitting antenna array and a receiving antenna array arranged in an alternating interleaved sequence on the same plane, which can simultaneously transmit uplink signals and receive downlink signals in different frequency bands.

## BACKGROUND

With the development of 5G communication technology, it is anticipated that future trends will lead to a 6G communication technology. Recently, phased array antennas have been applied to satellite communications, particularly low-Earth orbit (LEO) satellite communications. Technically, LEO satellite communications can address the challenges faced in mobile communications, wherein radio frequency (RF) signals cannot cover rugged terrain. Moreover, from a business perspective, companies like Starlink and Amazon in the West have already launched satellites into low-Earth orbit, aiming to establish communications between ground-based transceivers and LEO satellites. This shows that the global market for ground communication equipment for LEO satellites is booming.

A phased array antenna consists of multiple antennas combined with communication devices that control their phases. By adjusting the phase of each individual antenna, beams can be directed in specific orientations at different times and in different spatial regions. For example, a high-directivity array $32 \times 32$ antenna has a gain that is greater than 30 dBi and a beam width of less than 3.5°. The space between adjacent antennas can range from a half-wave length ($\lambda$/2) to a quarter-wave length ($\lambda$/4), with the preferred space being a half-wave length ($\lambda$/2). Additionally, these high-directivity array antennas also exhibit minimal point errors and reduced grating lobes.

In reality, when a transceiver transmits RF signals (also referred to as uplink signals), it operates at frequencies from 27.5 GHz to 30 GHz. However, when the transceiver receives RF signals (also referred to as downlink signals), it operates from 17.7 GHz to 20.2 GHz. If a transceiver transmits and receives uplink and downlink signals in different frequency bands simultaneously, the uplink signal and the downlink signal may interfere with each other between the phase-array antenna at the transmitting end (also referred to as transmitting array antenna) and the phase-array antenna at the receiving end (also referred to as receiving array antenna). Moreover, with antenna-in-package construction, the space between transmitting array antennas is 5.36 mm, whereas the space between receiving array antennas is 8.33 mm. This results in the space between a transmitting antenna and the adjacent receiving antenna not adhering to the optimal ratio of $\dfrac{1}{\sqrt{2}}$.

To resolve the interference between uplink and downlink signals, a common solution is to arrange transmitting array antennas and receiving array antennas in a staggered arrangement. However, in this arrangement, because the area of the transmitting array antenna is smaller than the area of the receiving array antenna, the transmitting array antenna and the receiving array antenna partially overlap each other. Therefore, the uplink signal and downlink signal will still interfere with each other.

Although the current transceiver is expected to encapsulate the above-mentioned antennas in a housing of the same size to effectively reduce the size of the transceiver, the aforementioned problems cannot be solved.

US 2020/0035625 A1 discloses a semiconductor package including a semiconductor die and a first insulating encapsulation, a substrate, and a second insulating encapsulation. The first insulating encapsulation encapsulates the semiconductor die. The substrate includes a redistribution circuitry, wherein the substrate is electrically coupled to the semiconductor package through the redistribution circuitry. The second insulating encapsulation is disposed on and partially covers the substrate, wherein the substrate is sandwiched between the semiconductor package and the second insulating encapsulation.

US 11,217,543 B2 discloses an antenna module that includes a fan-out semiconductor package including an IC, an encapsulant encapsulating at least a portion of the IC, a core member having a first side surface facing the IC or the encapsulant, and a connection member including at least one wiring layer electrically connected to the IC and the core member and at least one insulating layer, and an antenna package including a plurality of first directional antenna members configured to transmit or receive a first RF signal. The fan-out semiconductor package further includes at least one second directional antenna member disposed on a second side surface of the core member opposing the first side surface of the core member, stood up from a position electrically connected to at least one wiring layer, and configured to transmit or receive a second RF signal.

US 10,505,255 B2 discloses a semiconductor device package that includes a radio frequency front end circuit configured to process radio frequency signals, a first antenna, an antenna substrate, and a first conductive barrier. The first antenna is configured to transmit/receive a first radio frequency signal. The antenna substrate includes the first antenna. The antenna substrate is configured to transfer the first radio frequency signal between the radio frequency front end circuit and the first antenna. The first conductive barrier is configured to electromagnetically and electrostatically isolate the first antenna.

US 2020/185299 A1 discloses a semiconductor package with a semiconductor chip, a first mold compound layer at least partially covering the semiconductor chip, and a redistribution layer over the first mold compound layer. The redistribution layer includes one or more electrically conductive lines in electrical connection with the semiconductor chip. The semiconductor package may additionally include a second mold compound layer over the redistribution layer, and an antenna array over the second mold compound layer, the antenna array configured to be coupled to the one or more electrically conductive lines

TW M 637 071 U discloses a radio frequency package radiation structure including a multi-layer conductive wiring substrate, a plurality of radio frequency radiation structures, a plurality of high frequency transmitting radio frequency integrated circuit chips, a plurality of low frequency receiving radio frequency integrated circuit chips.

## Summary

The invention is defined as an antenna-in-package construction according to the independent claims. Preferred embodiments are defined in the dependent claims.

The disclosure provides an antenna-in-package construction with frequency division duplex technology. The antenna-in-package construction includes a chip layer, a second dielectric layer, and a first dielectric layer having the same or a different dielectric constant than the second dielectric layer that are stacked in order, and further includes a transmitting array antenna, a receiving array antenna, and a plurality of metal isolation pillars. The first dielectric layer has a dielectric constant that is more than 3.5. The transmitting antenna array extends from the chip layer to the first dielectric layer through the second dielectric layer. The receiving antenna array extends from the chip layer to the second dielectric layer, wherein the transmitting antenna array and the receiving antenna array are arranged in an alternating interleaved sequence. The plurality of metal isolated pillars surround each transmitting antenna and each receiving antenna. Additionally, the chip layer includes at least one transmitting chip and at least one receiving chip. The transmitting chip is electrically connected to the transmitting antenna array, and the receiving chip is electrically connected to the receiving antenna array. The transmitting array antenna includes a plurality of first antennas, and each first antenna is spaced a first distance from the adjacent first antenna, wherein the first distance is close to a half-wave length. The receiving array antenna includes a plurality of second antennas, and each second antenna is spaced a second distance from the adjacent second antenna, wherein the second distance is close to the half-wave length and is different from the first distance.

## BRIEF DESCRIPTION OF the DRAWINGS

The present invention can be more fully understood by reading the subsequent detailed description and examples with references made to the accompanying drawings, wherein:

FIG. 1 is a partial side view illustrating an antenna-in-package construction according to an embodiment.
FIG. 2 is a partial bottom view illustrating an antenna-in-package construction according to an embodiment.
FIG. 3 is a schematic three-dimensional view illustrating an antenna-in-package construction according to an embodiment.
FIG. 4 is a diagram illustrating a method for performing wireless communication according to an embodiment.
FIG. 5A to FIG. 5D are partial side views of manufacturing the antenna-in-package construction at various stages according to an embodiment.

## Detailed Description

This embodiment discloses an antenna-in-package construction 100, which measures $256 \times 256$ square millimeters ($mm^2$) and is applied to frequency division duplex (FDD) technology in wireless communication systems. The antenna-in-package construction 100 may be composed of a Complementary Metal Oxide Semiconductor (CMOS) chip and a 1024 array antenna, wherein the CMOS chip is manufactured by advanced processes. The wireless communication system may be consist of low-Earth orbit satellites and ground-based transceivers and employ frequency division duplex technology. Frequency division duplex technology involves simultaneous transmitting uplink signals with a first frequency band and receiving downlink signals with a second frequency band. Here, the first frequency band is the Ka-band, while the second frequency band ranges from the Ku-band to the K-band. The first frequency band and the second frequency band are different. The Ka-band frequency ranges from about 27 GHz to 40 GHz, with a wavelength ranges from about 11.11 mm to 7.50 mm. The Ku-band frequency ranges from about 12 GHz to 18 GHz, with a wavelength ranges from about 25.00mm to 16.67 mm. The K-band frequency ranges from about 18 GHz to 27 GHz, with a wavelength ranges from about 16.67mm to 11.11 mm.

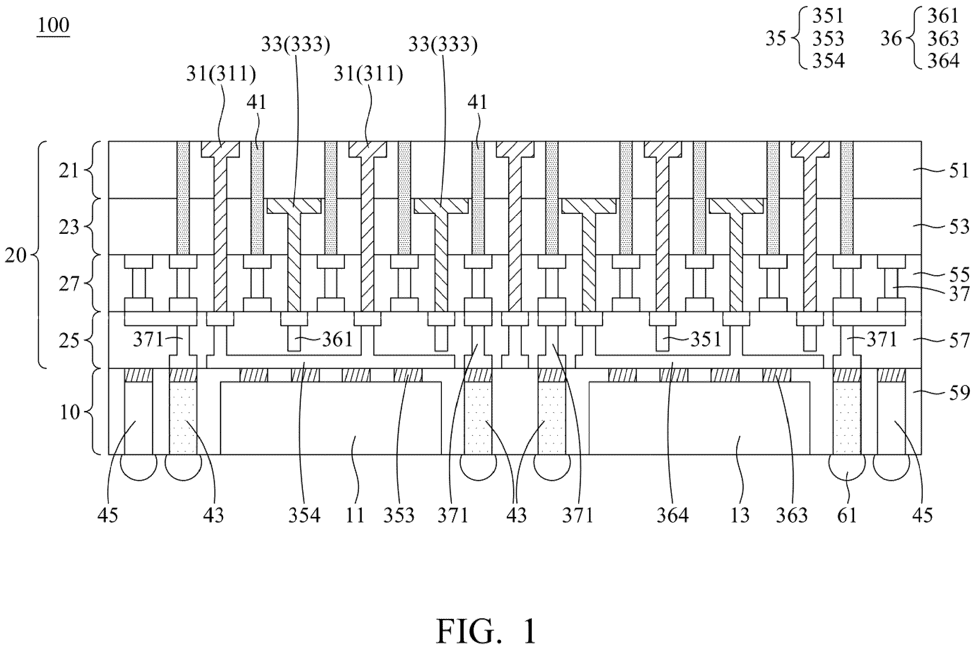

Referring to Figure 1, the antenna-in-package construction 100 includes a chip layer 10 and a packaging stacked layer 20. The chip layer 10 includes one or more transmitting chips 11 and multiple receiving chips 13. The transmitting chip (TX chip) includes a power amplifier (PA). The receiving chip (RX chip) includes a low noise amplifier (LNA). The packaging stacked layer 20 includes a first dielectric layer 21, a second dielectric layer 23, a redistribution wiring layer 25, and a grounding layer 27. Moreover, as shown in FIG. 1, in this embodiment, the packaging stacked layer 20 further includes transmitting antenna arrays 31 and receiving antenna array 33 that are arranged in an alternating interleaved sequence, as well as multiple metal isolation pillars 41 and 43.

The chip layer 10 may further include one or more radio frequency front-end modules (FEM), one or more analog beamforming circuits, and one or more digital beamforming (DBF) circuits.

In this embodiment, both the transmitting chip 11 and receiving chip 13 may be made of silicon (Si), silicon germanium (SiGe), gallium nitride (GaN), gallium arsenide (GaAs), compound semiconductor, or any other suitable material. Optionally, the chip layer 10 may include an electromagnetic shielding layer.

The packaging stacked layer 20 may be a multilayer board that is consisted of two or more layers and include low-temperature co-fired ceramic (LTCC), FR-4 epoxy glass fabric, RO high-frequency circuit board, silicon, glass, gallium arsenide, silicon nitride, thermal interface materials (TIM), any other suitable material, or a combination thereof. The thermal interface materials may include thermal grease, thermal gel, phase-change materials, phase-change metal alloys, thermally conductive adhesives, any other suitable material, or a combination thereof.

The first dielectric layer 21 is composed of a first dielectric material 51 and is disposed above the chip layer 10, wherein the first dielectric material 51 fills the spaces excluding the transmitting array antenna 31 and the metal isolation pillars 41. In this embodiment, the dielectric constant of the first dielectric material 51 is higher than the dielectric constant of air. For instance, the dielectric constant of the first dielectric material 51 may range from about 3 to 13, such as from about 3 to 4 (e.g., polyimide with a dielectric constant of about 3.5) or from about 10 to 13 (e.g., silicon with a dielectric constant of about 11.9 or gallium arsenide with a dielectric constant of about 12.9). The first dielectric material 51 may include any suitable dielectric material, such as low-temperature co-fired ceramic (LTCC), FR-4 epoxy glass fabric, RO high-frequency circuit board, silicon, glass, gallium arsenide, thermal interface materials (TIM), photosensitive materials (e.g., polyimide), any other suitable high dielectric constant material, or a combination thereof, but is not limited thereto.

The second dielectric layer 23 is composed of a second dielectric material 53 and is disposed between the chip layer 10 and the first dielectric layer 21. The second dielectric material 53 fills the spaces excluding the transmitting array antenna 31, receiving array antenna 33, and metal isolation pillars 41. In this embodiment, the second dielectric material 53 may be the same or similar to the first dielectric material 51, but the present disclosure is not limited thereto. In this embodiment, the dielectric constant of the second dielectric material 53 is less than that of the first dielectric material 51.

The redistribution wiring layer 25 is disposed between the chip layer 10 and the second dielectric layer 23 and includes a first antenna chip conductive wire 35 and a second antenna chip conductive wire 36. The first antenna chip conductive wire 35 includes (or is divided into) multiple conductive wires 351, 353, 354, and the conductive wires 351, 353, 354 electrically connect the transmitting array antenna 31 with the transmitting chip 11. The second antenna chip conductive wire 36 includes (or is divided into) multiple conductive wires 361, 363, 364, and the conductive wires 361, 363, 364 electrically connect the receiving array antenna 33 with the receiving chip 13. The conductive wires 351, 353, 354, 361, 363, 364 may include conductive materials, such as metals, metal silicides, similar materials, or a combination thereof.

The grounding layer 27 is disposed between the redistribution wiring layer 25 and the second dielectric layer 23. The grounding layer 27 includes multiple grounding pillars 37 that ground the metal isolation pillars 41. In addition, the redistribution wiring layer 25 also includes multiple grounding conductive wires 371. The grounding pillars 37 ground the metal isolation pillars 41 through the grounding conductive wires 371. The grounding pillars 37 and the grounding conductive wires 371 may include materials that are the same or similar to the conductive wires 351, 353, 354, 361, 363, and 364, which will not be repeated here, but the present disclosure is not limited thereto.

The transmitting array antenna 31 includes multiple first antennas 311 (also referred to as transmitting antennas) and extends from the first dielectric layer 21 to the chip layer 10 to be electrically connected to the transmitting chip 11. Furthermore, the distance between each first antenna 311 and the adjacent first antenna 311 is the first distance ($\lambda_U$), which is close to a half-wave length.

The receiving array antenna 33 includes multiple second antennas 333 (also referred to as receiving antennas) and extends from the second dielectric layer 23 to the chip layer 10 to be electrically connected to the receiving chip 13. Furthermore, the distance between each second antenna 333 and the adjacent second antenna 333 is the second distance ($\lambda_D$), which is close to the half-wave length, wherein the second distance and the first distance may be the same or different. For example, the first distance is $0.528\lambda_U = 0.528 \times 5.36 = 2.83008$ millimeters (mm), the second distance is $0.48\lambda_D = 0.48 \times 8.33 = 3.9984$ millimeters (mm), and the ratio of the first distance to the second distance is 0.707.

In this embodiment, the transmitting array antenna 31 and the receiving array antenna 33 may include gold, tin, silver, copper, nickel, any other suitable metal or alloy. Moreover, the transmitting array antenna 31 and the receiving array antenna 33 may be formed by processes like electroplating, chemical plating, printing processes, other suitable processes or combinations thereof, but the present disclosure is not limited thereto.

In this embodiment, the number of transmitting array antennas 31 may be an integer multiple of the number of receiving array antennas 33, preferably twice as many. For example, there are 128 first antennas 311 in the transmitting array antenna 31, while there are 64 second antennas 333 in the receiving array antenna 33.

The metal isolation pillars 41 surround each first antenna 311 and each second antenna 333 to prevent the first antenna 311 and the second antenna 333 from interfering with each other. The metal isolation pillar 41 may include metals, such as gold (Au), nickel (Ni), platinum (Pt), palladium (Pd), iridium (Ir), titanium (Ti), chromium (Cr), tungsten (W), aluminum (Al), copper (Cu), tin (Sn), silver (Ag), a similar material, an alloy thereof, or a combination thereof. In this embodiment, the metal isolation pillars 41 are made of copper, but the present disclosure is not limited thereto.

The metal isolation pillars 43 surround the transmitting chip 11 and the receiving chip 12 to prevent the transmitting chip 11 and receiving chip 12 from interfering with each other. For example, the metal isolation pillar 43 may include materials that are the same as or similar or the metal isolation pillar 41, which will not be repeated here, but the present disclosure is not limited thereto.

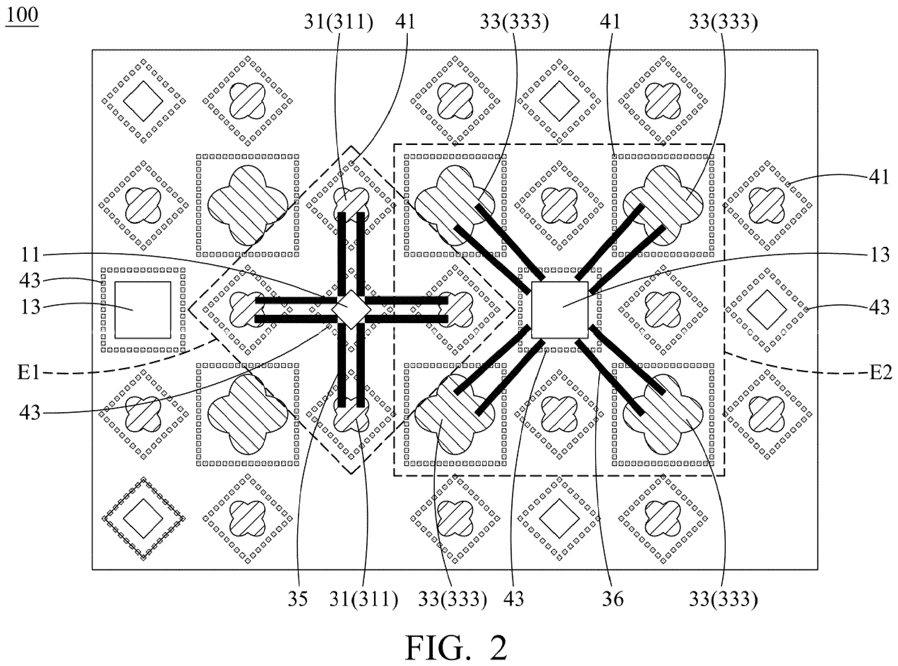

Referring to FIG. 1 and FIG. 2, in this embodiment, multiple first antennas 311 are arranged in one (or more) array(s), multiple second antennas 333 are arranged in one (or more) array(s), and the first antennas 311 and the second antennas 333 are arranged in an interleaved sequence. As shown in FIG. 1 and FIG. 2, in this embodiment, each transmitting chip 11 is electrically connected to four first antennas 311 (as shown in region E1 in FIG. 2), and each receiving chip 13 is electrically connected to four second antennas 333 (as shown in region E2 in FIG. 2), but the present disclosure is not limited thereto. In this embodiment, each transmitting chip 11 is electrically connected with two or more than four first antennas 311, and each receiving chip 13 is electrically connected with two or more than four second antennas 333. The arrangement and (electrical) connection of the transmitting array antenna 31 and receiving array antenna 33 may be designed or adjusted according to actual needs.

In the bottom view, after rotating each first antenna 311 by 45 degrees, each second antenna 333 has the same shape as each first antenna 311 but with different sizes. For instance, the top surfaces of both the first antenna 311 and the second antenna 333 are shaped like a clover. Furthermore, the top area of the first antenna 311 is smaller than the top area of the second antenna 333, but the present disclosure is not limited thereto.

Similarly, in the bottom view, the top surfaces of the first antenna 311 and the second antenna 333 may be rectangles, circles, ellipses, or other shapes, or the top area of the first antenna 311 may be equal to the top area of the second antenna 333. For example, each first antenna 311 is a rectangle, and each second antenna 333 is a diamond formed by rotating a rectangle, with the edge corner of the diamond that faces one side edge of the adjacent rectangle.

Similarly, in the bottom view, after rotating each receiving chip 13 by 45 degrees, each receiving chip 13 has the same shape as each transmitting chip 11 but with different sizes. For instance, the top surfaces of both the transmitting chip 11 and the receiving chip 13 are rectangular, and the top area of the transmitting chip 11 is smaller than the top area of the receiving chip 13, but the present disclosure is not limited thereto. In this embodiment, the top surfaces of the transmitting chip 11 and the receiving chip 13 may be other shapes, or the top area of the transmitting chip 11 may be equal to the top area of the receiving chip 13.

Similarly, the antenna-in-package construction 100 further includes dielectric layers 55 and 57. The dielectric layer 55 is disposed within the grounding layer 27 and fills the spaces excluding the transmitting array antenna 31, the receiving array antenna 33, and the grounding pillars 37. The dielectric layer 57 is disposed within the redistribution wiring layer 25 and fills the spaces excluding the conducting wires 351, 353, 354, 361, 363, 364, and the grounding conductive wire 371, but the present disclosure is not limited thereto.

In this embodiment, the transmitting array antenna 31 operates in the first frequency band, while the receiving array antenna 33 operates in the second frequency band. The first frequency band is determined by the top area of the first antenna 311 and the dielectric constant of the dielectric layer 51, whereas the second frequency band is determined by the top area of the second antenna 333 and the dielectric constant of the dielectric layer 53.

In this embodiment, the antenna-in-package construction 100 further includes conductive pillars 45 disposed within the chip layer 10 for electrically connecting other conductive components in the chip layer 10 (e.g., other chips, conductive pads, etc.) to external or internal components of the antenna-in-package construction 100.

In this embodiment, the antenna-in-package construction 100 includes a protective material 59 disposed within the chip layer 10 and fills the space excluding the transmitting chip 11, the receiving chip 13, the metal isolation pillars 43, and the conductive pillars 45, but the present disclosure is not limited thereto. The protective material 59 may include molding compounds, mold underfill (MUF), other suitable materials, or a combination thereof, but the present disclosure is not limited thereto.

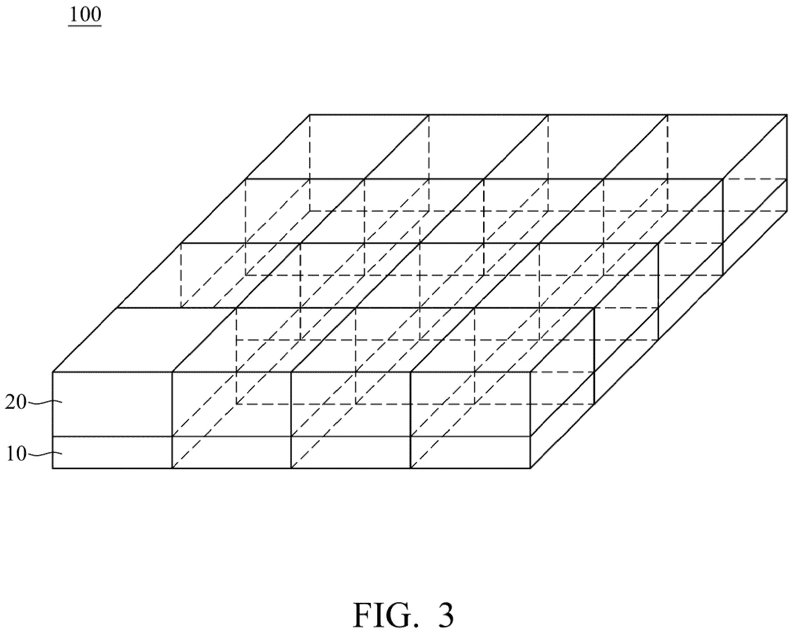

Referring to FIG. 3, multiple packaging stacked layers 20 are respectively disposed above the corresponding chip layer 10. Here, each packaging stacked layer 20 may include at least one region E1 (i.e., a transmitting chip 11 is electrically connected to four first antennas 311) and region E2 (i.e., a receiving chip 13 is electrically connected to four second antennas 333). In other words, in FIG. 3, the antenna-in-package construction 100 may include sixteen transmitting chips 11 with their corresponding sixty-four first antennas 311, and sixteen receiving chips 13 with their corresponding sixty-four second antennas 333, but the present disclosure is not limited thereto.

Referring again to FIG. 3, regarding the manufacturing method of the antenna-in-package construction 100, the panel-level package (PLP) process may be adopted, which uses large-area substrates to enhance the production of massive planar antenna arrays.

In this embodiment, the interleaved array of the antenna-in-package construction 100 may support multi-band receiving/transmitting antenna arrays. It may perform frequency division duplexing (FDD) communication processing in the mobile devices of wireless communication systems, integrating both the transmitting antenna (TX) and the receiving antenna (RX) into a single module for miniaturization, thereby replacing the traditional two sets of non-shared antenna structures. Furthermore, according to the embodiment, the antenna-in-package construction 100 may overcome issues such as mutual interference between the transmitting antenna (TX) and the receiving antenna (RX), point error of the antenna beam, and grating lobes caused by the gap between the uplink and downlink carrier frequencies in the Ka-band.

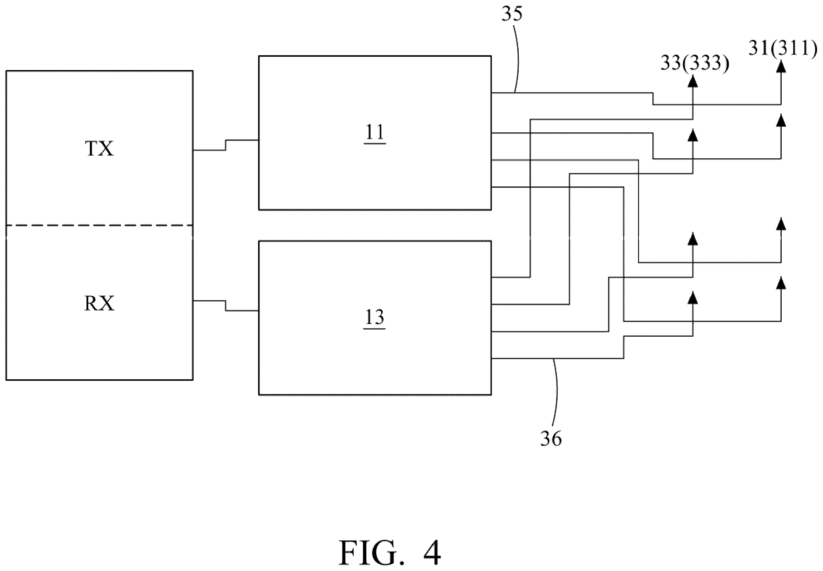

Referring to FIG. 4, through the antenna-in-package construction 100, frequency division duplexing is implemented. The transmission signal TX emitted by the transmitting chip 11 is transmitted to the transmitting array antenna 31 through the first antenna chip conductive wire 35 and emitted outside the antenna-in-package construction 100. At the same time, the reception signal RX received by the receiving array antenna 33 is transmitted to the receiving chip 33 for signal processing through the second antenna chip conductive wire 36. In this embodiment, the transmitting array antenna 31 operates at the first frequency band, the receiving array antenna 33 operates at the second frequency band, and the first frequency band and the second frequency band are different.

Unlike time division duplexing (TDD), frequency division duplexing uses two frequency channels to transmit and receive signals. Because the operation time is continuous, during high-speed movement (e.g., on a high-speed train or receiving signals from low-Earth orbit satellites), the resource allocation of frequency division duplexing is large. Electronic devices (e.g., mobile phones) that include the antenna-in-package construction 100 transmit (uplink) and receive (downlink) simultaneously. If the electronic device detects a deterioration in the quality of the receiving channel (downlink), it can quickly inform the base station (e.g., a cellular base station or low-Earth orbit satellite) for adjustments through the transmitting channel (uplink).

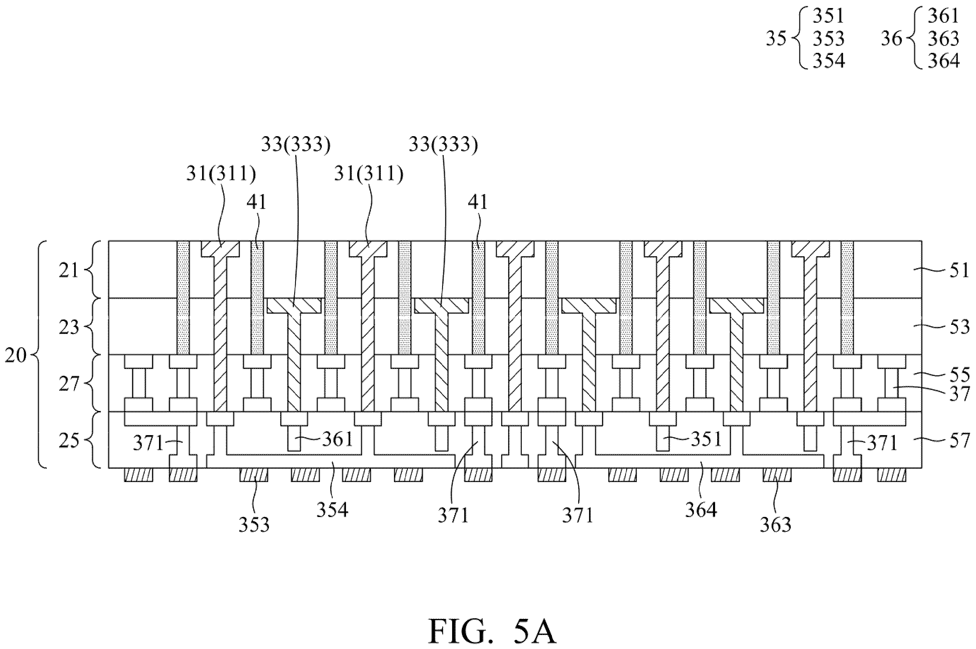

Referring to FIG. 5A to FIG. 5D, the internal structure of the antenna-in-package construction 100 is shown in a partially transparent manner. In other words, when observing the side of the antenna-in-package construction 100 in reality, it may not be possible to see every component shown in FIG. 5A to FIG. 5D. Moreover, some components of the antenna-in-package construction 100 are omitted in FIG. 5A to FIG. 5D for the sake of brevity.

Referring to FIG. 5A, a method for manufacturing the packaging stacked layer 20 is provided. The packaging stacked layer 20 sequentially includes a redistribution wiring layer 25, a grounding layer 27, a second dielectric layer 23, and a first dielectric layer 21. The transmitting array antenna 31 (that includes multiple first antennas 311) is disposed in the first dielectric layer 21 and extends from the first dielectric layer 21 to the redistribution wiring layer 25. The receiving array antenna 33 (that includes multiple second antennas 333) is disposed in the second dielectric layer 23 and extends from the second dielectric layer 23 to the redistribution wiring layer 25. Multiple metal isolation pillars 41 surround each first antenna 311 and each second antenna 333 to prevent the transmitting array antenna 31 and the receiving array antenna 33 from interfering with each other.

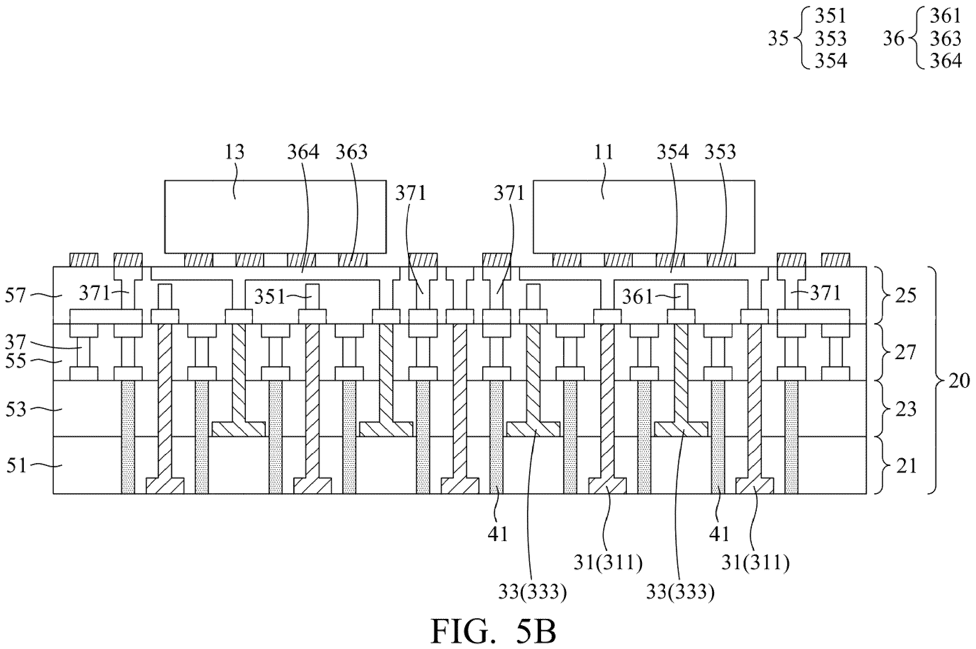

Referring to FIG. 5B, the packaging stacked layer 20 is inverted, and multiple transmitting chips 11 and multiple receiving chips 13 are formed on the redistribution wiring layer 25 (only one transmitting chip 11 and one receiving chip 13 are illustrated in FIG. 5B). The transmitting chips 11 are electrically connected to the transmitting array antenna 31, and the receiving chips 13 are electrically connected to the receiving array antenna 33.

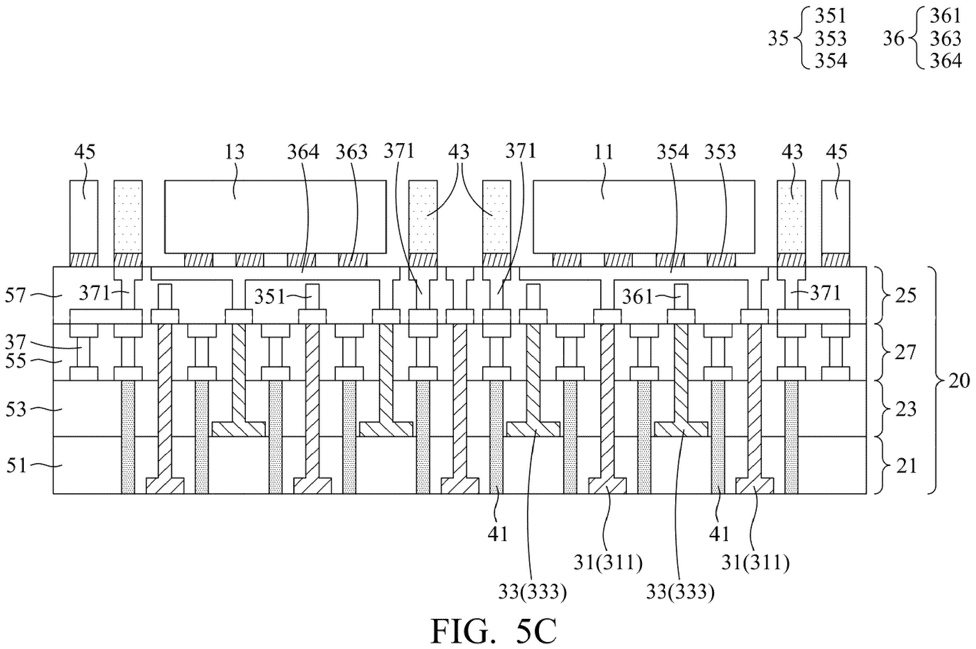

Referring to FIG. 5C, metal isolation pillars 43 are formed around the transmitting chips 11 and the receiving chips 12 to prevent the transmitting chips 11 and the receiving chips 12 from interfering with each other. In this embodiment, when forming the metal isolation pillars 43, conductive pillars 45 are also formed, but the present disclosure is not limited thereto.

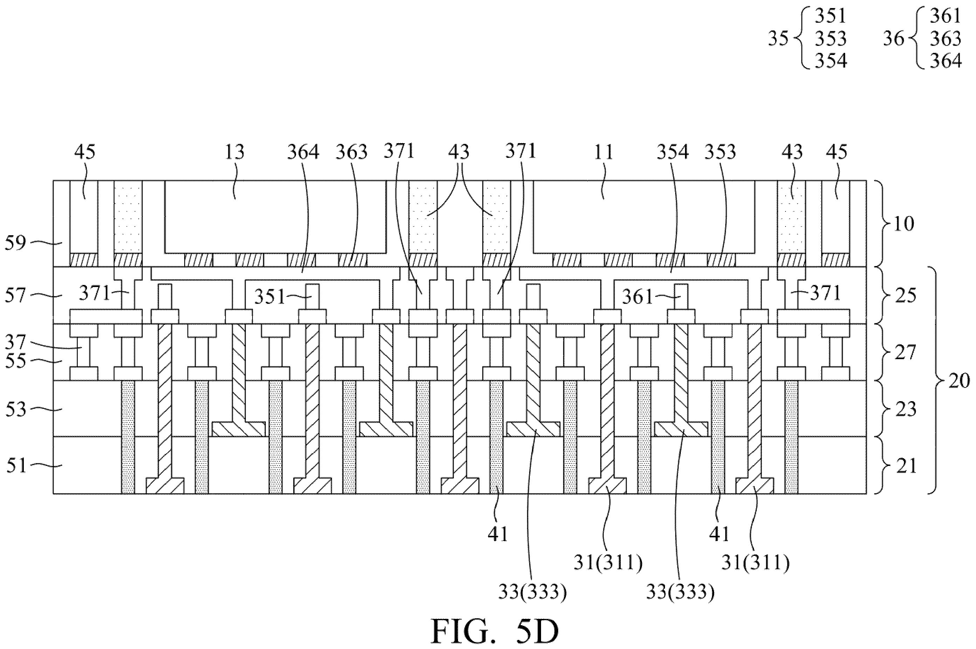

Referring to FIG. 5D, a protective material 59 is formed on the redistribution wiring layer 25. In more detail, the protective material 59 is formed between the transmitting chips 11, the receiving chips 13, the metal isolation pillars 43, and the conductive pillars 45, exposing (at least part of) the surface of the transmitting chips 11, the receiving chips 13, the metal isolation pillars 43, and the conductive pillars 45.

Then, referring back to FIG. 1, multiple solder balls 61 are formed and connected to the metal isolation pillars 43 and the conductive pillars 45 to form the antenna-in-package construction 100. More specifically, each metal isolation pillar 43 and each conductive pillar 45 are in direct contact with the corresponding solder ball 61. Finally, the antenna-in-package construction 100 may be electrically connected to another conductive substrate (not shown) through the solder balls 61, which is a type of flip-chip bonding, but the present disclosure is not limited thereto. In this embodiment, the antenna-in-package construction 100 may also be electrically connected to another conductive substrate using wire bonding.

In summary, according to the embodiment, the antenna-in-package construction may be arranged in an interleaved pattern between the transmitting array antenna and the receiving array antenna, approximating the aforementioned optimal space and optimal ratio to avoid interference between the uplink and downlink signals. Additionally, the antenna-in-package construction may also reduce issues such as the point errors of the antenna beam and grating lobes.

**Claims**

1. An antenna-in-package construction which is configured to transmit an uplink signal and to receive a downlink signal that have different frequency bands, comprising:

   a chip layer (10) comprising at least one transmitting chip (11) and at least one receiving chip (13);
   a first dielectric layer (21) on the chip layer, wherein the first dielectric has a dielectric constant that is higher than 3.5;
   a second dielectric layer (23) between the chip layer and the first dielectric layer;
   a transmitting array antenna (31) comprising a plurality of first antennas (311), electrically connected to the transmitting chip and extending from the transmitting chip to the first dielectric layer, wherein each of the first antennas is spaced a first distance from an adjacent one of the first antennas, and the first distance is close to a half-wave length;
   a receiving array antenna (33) comprising a plurality of second antennas (333), electrically connected to the receiving chip and extending from the receiving chip to the second dielectric layer, wherein the transmitting array antenna (31) and the receiving array antenna (33) are arranged in an alternating interleaved sequence, and each of the second antennas is spaced a second distance from an adjacent one of the second antennas, and the second distance is close to the half-wave length and is different from the first distance; and
   a plurality of metal isolation pillars (41) surrounding each of the first antennas and each of the second antennas.

2. The antenna-in-package construction as claimed in claim 1, wherein the first distance is less than the second distance.

3. The antenna-in-package construction as claimed in claims 1 or 2, wherein an area of each of the first antennas is different from an area of each of the second antennas.

4. The antenna-in-package construction as claimed in any of claims 1 to 3, wherein an area of each of the first antennas is smaller than an area of each of the second antennas.

5. The antenna-in-package construction as claimed in any of claims 1 to 4, wherein a length of each of the first antennas is longer than a length of each of the second antennas.

6. The antenna-in-package construction as claimed in any of claims 1 to 5, wherein each of the first antennas comprises at least one side edge, and each of the second antennas includes at least one edge corner, wherein the edge corner of the second antenna faces the side edge of an adjacent one of the first antennas.

7. The antenna-in-package construction as claimed in any of claims 1 to 6, wherein each of the first antennas and each of the second antennas have the same shape.

8. The antenna-in-package construction as claimed in any of claims 1 to 7, wherein the number of first antennas is an integer multiple of the number of second antennas.

9. The antenna-in-package construction as claimed in any of claims 1 to 8, wherein the uplink signal has a first frequency band ranging from 27 GHz to 40 GHz, and the downlink signal has a second frequency band ranging from 17 GHz to 27 GHz.

10. The antenna-in-package construction as claimed in any of claims 1 to 9, wherein a dielectric constant of the second dielectric layer is different from a dielectric constant of the first dielectric layer.

11. The antenna-in-package construction as claimed in any of claims 1 to 9, wherein the dielectric constant of the second dielectric layer is the same as the dielectric constant of the first dielectric layer.

12. The antenna-in-package construction as claimed in any of claims 1 to 11, further comprising:
   a redistribution wiring layer (25) comprising a plurality of conductive lines (35, 36) and disposed between the chip layer and the second dielectric layer, wherein the redistribution wiring layer is used for electrically connecting each of the first antennas to the transmitting chip and electrically connecting each of the second antennas to the receiving chip.

13. The antenna-in-package construction as claimed in any of claims 1 to 12, wherein the metal isolation pillars are also around the transmitting chip and the receiving chip.

14. The antenna-in-package construction as claimed in any of claims 1 to 13, further comprising:
a grounding layer (27) comprising a plurality of grounding pillars (37), wherein the grounding layer is used for grounding the metal isolation pillars.

15. An antenna-in-package construction which is configured to transmit an uplink signal and to receive a downlink signal that have different frequency bands, comprising:

a chip layer (10) comprising at least one transmitting chip (11) and at least one receiving chip (13);
a first dielectric layer (21) on the chip layer, wherein the first dielectric has a dielectric constant that is higher than 3.5;
a second dielectric layer (23) between the chip layer and the first dielectric layer;
a transmitting array antenna (31) comprising a plurality of first antennas (311), electrically connected to the transmitting chip and extending from the transmitting chip to the second dielectric layer, wherein each of the first antennas is spaced a first distance from an adjacent one of the first antennas, and the first distance is close to a half-wave length;
a receiving array antenna (33) comprising a plurality of second antennas (333), electrically connected to the receiving chip and extending from the receiving chip to the first dielectric layer, wherein the transmitting array antenna (31) and the receiving array antenna (33) are arranged in an alternating interleaved sequence, and each of the second antennas is spaced a second distance from an adjacent one of the second antennas, and the second distance is close to the half-wave length and is different from the first distance; and
a plurality of metal isolation pillars (41) surrounding each of the first antennas and each of the second antennas.

**Patentansprüche**

1. Antenne-im-Package-Aufbau, der eingerichtet ist, ein Uplink-Signal zu senden und ein Downlink-Signal zu empfangen, die unterschiedliche Frequenzbänder aufweisen, umfassend:

eine Chipschicht (10), die mindestens einen Sendechip (11) und mindestens einen Empfangschip (13) umfasst;

eine erste dielektrische Schicht (21) auf der Chipschicht, wobei das erste Dielektrikum eine Dielektrizitätskonstante aufweist, die höher als 3,5 ist;
eine zweite dielektrische Schicht (23) zwischen der Chipschicht und der ersten dielektrischen Schicht;
eine Sende-Array-Antenne (31), die eine Mehrzahl von ersten Antennen (311) umfasst, die elektrisch mit dem Sendechip verbunden sind und sich von dem Sendechip zu der ersten dielektrischen Schicht erstrecken, wobei jede der ersten Antennen in einem ersten Abstand von einer benachbarten der ersten Antennen beabstandet ist und der erste Abstand nahe einer Halbwellenlänge liegt;
eine Empfangs-Array-Antenne (33), die eine Mehrzahl von zweiten Antennen (333) umfasst, die elektrisch mit dem Empfangschip verbunden sind und sich von dem Empfangschip zu der zweiten dielektrischen Schicht erstrecken, wobei die Sende-Array-Antenne (31) und die Empfangs-Array-Antenne (33) in einer abwechselnden verschachtelten Sequenz angeordnet sind und jede der zweiten Antennen in einem zweiten Abstand von einer benachbarten der zweiten Antennen beabstandet ist und der zweite Abstand nahe der Halbwellenlänge liegt und sich von dem ersten Abstand unterscheidet; und
eine Mehrzahl von Metallisolationssäulen (41), die jede der ersten Antennen und jede der zweiten Antennen umgeben.

2. Antenne-im-Package-Aufbau nach Anspruch 1, wobei der erste Abstand kleiner als der zweite Abstand ist.

3. Antenne-im-Package-Aufbau nach Anspruch 1 oder 2, wobei sich eine Fläche jeder der ersten Antennen von einer Fläche jeder der zweiten Antennen unterscheidet.

4. Antenne-im-Package-Aufbau nach einem der Ansprüche 1 bis 3, wobei eine Fläche jeder der ersten Antennen kleiner als eine Fläche jeder der zweiten Antennen ist.

5. Antenne-im-Package-Aufbau nach einem der Ansprüche 1 bis 4, wobei eine Länge jeder der ersten Antennen länger als eine Länge jeder der zweiten Antennen ist.

6. Antenne-im-Package-Aufbau nach einem der Ansprüche 1 bis 5, wobei jede der ersten Antennen mindestens eine Seitenkante umfasst und jede der zweiten Antennen mindestens eine Kantenecke umfasst, wobei die Kantenecke der zweiten Antenne der Seitenkante einer benachbarten der ersten An-

**7.** Antenne-im-Package-Aufbau nach einem der Ansprüche 1 bis 6, wobei jede der ersten Antennen und jede der zweiten Antennen die gleiche Form aufweisen.

**8.** Antenne-im-Package-Aufbau nach einem der Ansprüche 1 bis 7, wobei die Anzahl der ersten Antennen ein ganzzahliges Vielfaches der Anzahl der zweiten Antennen ist.

**9.** Antenne-im-Package-Aufbau nach einem der Ansprüche 1 bis 8, wobei das Uplink-Signal ein erstes Frequenzband im Bereich von 27 GHz bis 40 GHz aufweist und das Downlink-Signal ein zweites Frequenzband im Bereich von 17 GHz bis 27 GHz aufweist.

**10.** Antenne-im-Package-Aufbau nach einem der Ansprüche 1 bis 9, wobei sich eine Dielektrizitätskonstante der zweiten dielektrischen Schicht von einer Dielektrizitätskonstante der ersten dielektrischen Schicht unterscheidet.

**11.** Antenne-im-Package-Aufbau nach einem der Ansprüche 1 bis 9, wobei die Dielektrizitätskonstante der zweiten dielektrischen Schicht die gleiche wie die Dielektrizitätskonstante der ersten dielektrischen Schicht ist.

**12.** Antenne-im-Package-Aufbau nach einem der Ansprüche 1 bis 11, ferner umfassend: eine Umverdrahtungsschicht (25), die eine Mehrzahl von leitfähigen Leitungen (35, 36) umfasst und zwischen der Chipschicht und der zweiten dielektrischen Schicht angeordnet ist, wobei die Umverdrahtungsschicht zum elektrischen Verbinden jeder der ersten Antennen mit dem Sendechip und zum elektrischen Verbinden jeder der zweiten Antennen mit dem Empfangschip verwendet wird.

**13.** Antenne-im-Package-Aufbau nach einem der Ansprüche 1 bis 12, wobei sich die Metallisolationssäulen auch um den Sendechip und den Empfangschip herum befinden.

**14.** Antenne-im-Package-Aufbau nach einem der Ansprüche 1 bis 13, ferner umfassend: eine Erdungsschicht (27), die eine Mehrzahl von Erdungssäulen (37) umfasst, wobei die Erdungsschicht zum Erden der Metallisolationssäulen verwendet wird.

**15.** Antenne-im-Package-Aufbau, der eingerichtet ist, um ein Uplink-Signal zu senden und ein Downlink-Signal zu empfangen, die unterschiedliche Frequenzbänder aufweisen, umfassend:

eine Chipschicht (10), die mindestens einen Sendechip (11) und mindestens einen Empfangschip (13) umfasst;

eine erste dielektrische Schicht (21) auf der Chipschicht, wobei das erste Dielektrikum eine Dielektrizitätskonstante aufweist, die höher als 3,5 ist;

eine zweite dielektrische Schicht (23) zwischen der Chipschicht und der ersten dielektrischen Schicht;

eine Sende-Array-Antenne (31), die eine Mehrzahl von ersten Antennen (311) umfasst, die elektrisch mit dem Sendechip verbunden sind und sich von dem Sendechip zu der zweiten dielektrischen Schicht erstrecken, wobei jede der ersten Antennen in einem ersten Abstand von einer benachbarten der ersten Antennen beabstandet ist und der erste Abstand nahe einer Halbwellenlänge liegt;

eine Empfangs-Array-Antenne (33), die eine Mehrzahl von zweiten Antennen (333) umfasst, die elektrisch mit dem Empfangschip verbunden sind und sich von dem Empfangschip zu der ersten dielektrischen Schicht erstrecken, wobei die Sende-Array-Antenne (31) und die Empfangs-Array-Antenne (33) in einer abwechselnden verschachtelten Sequenz angeordnet sind und jede der zweiten Antennen in einem zweiten Abstand von einer benachbarten der zweiten Antennen beabstandet ist und der zweite Abstand nahe der Halbwellenlänge liegt und sich von dem ersten Abstand unterscheidet; und

eine Mehrzahl von Metallisolationssäulen (41), die jede der ersten Antennen und jede der zweiten Antennen umgeben.

## Revendications

**1.** Construction d'antenne en boîtier qui est configurée pour transmettre un signal de liaison montante et pour recevoir un signal de liaison descendante qui ont des bandes de fréquences différentes, comprenant :

une couche de puce (10) comprenant au moins une puce de transmission (11) et au moins une puce de réception (13) ;

une première couche diélectrique (21) sur la couche de puce, dans laquelle le premier diélectrique a une constante diélectrique qui est supérieure à 3,5 ;

une seconde couche diélectrique (23) entre la couche de puce et la première couche diélectrique ;

une antenne réseau de transmission (31) comprenant une pluralité de premières antennes (311), connectées électriquement à la puce de transmission et s'étendant de la puce de transmission à la première couche diélectrique, dans laquelle chacune des premières antennes est espacée d'une première distance d'une antenne adjacente des premières antennes, et la première distance est proche d'une demi-longueur d'onde ;

une antenne réseau de réception (33) comprenant une pluralité de secondes antennes (333), connectées électriquement à la puce de réception et s'étendant de la puce de réception à la seconde couche diélectrique, dans laquelle l'antenne réseau de transmission (31) et l'antenne réseau de réception (33) sont agencées dans une séquence entrelacée alternée, et chacune des secondes antennes est espacée d'une seconde distance d'une antenne adjacente des secondes antennes, et la seconde distance est proche de la demi-longueur d'onde et est différente de la première distance ; et

une pluralité de piliers d'isolation métalliques (41) entourant chacune des premières antennes et chacune des secondes antennes.

2. Construction d'antenne en boîtier selon la revendication 1, dans laquelle la première distance est inférieure à la seconde distance.

3. Construction d'antenne en boîtier selon la revendication 1 ou 2, dans laquelle une aire de chacune des premières antennes est différente d'une aire de chacune des secondes antennes.

4. Construction d'antenne en boîtier selon l'une quelconque des revendications 1 à 3, dans laquelle une aire de chacune des premières antennes est plus petite qu'une aire de chacune des secondes antennes.

5. Construction d'antenne en boîtier selon l'une quelconque des revendications 1 à 4, dans laquelle une longueur de chacune des premières antennes est plus longue qu'une longueur de chacune des secondes antennes.

6. Construction d'antenne en boîtier selon l'une quelconque des revendications 1 à 5, dans laquelle chacune des premières antennes comprend au moins un bord latéral, et chacune des secondes antennes comprend au moins un coin de bord, dans laquelle le coin de bord de la seconde antenne fait face au bord latéral d'une antenne adjacente des premières antennes.

7. Construction d'antenne en boîtier selon l'une quelconque des revendications 1 à 6, dans laquelle chacune des premières antennes et chacune des secondes antennes ont la même forme.

8. Construction d'antenne en boîtier selon l'une quelconque des revendications 1 à 7, dans laquelle le nombre de premières antennes est un multiple entier du nombre de secondes antennes.

9. Construction d'antenne en boîtier selon l'une quelconque des revendications 1 à 8, dans laquelle le signal de liaison montante a une première bande de fréquences allant de 27 GHz à 40 GHz, et le signal de liaison descendante a une seconde bande de fréquences allant de 17 GHz à 27 GHz.

10. Construction d'antenne en boîtier selon l'une quelconque des revendications 1 à 9, dans laquelle une constante diélectrique de la seconde couche diélectrique est différente d'une constante diélectrique de la première couche diélectrique.

11. Construction d'antenne en boîtier selon l'une quelconque des revendications 1 à 9, dans laquelle la constante diélectrique de la seconde couche diélectrique est la même que la constante diélectrique de la première couche diélectrique.

12. Construction d'antenne en boîtier selon l'une quelconque des revendications 1 à 11, comprenant en outre :

une couche de câblage de redistribution (25) comprenant une pluralité de lignes conductrices (35, 36) et disposée entre la couche de puce et la seconde couche diélectrique, dans laquelle la couche de câblage de redistribution est utilisée pour connecter électriquement chacune des premières antennes à la puce de transmission et connecter électriquement chacune des secondes antennes à la puce de réception.

13. Construction d'antenne en boîtier selon l'une quelconque des revendications 1 à 12, dans laquelle les piliers d'isolation métalliques sont également autour de la puce de transmission et de la puce de réception.

14. Construction d'antenne en boîtier selon l'une quelconque des revendications 1 à 13, comprenant en outre :

une couche de mise à la terre (27) comprenant une pluralité de piliers de mise à la terre (37), dans laquelle la couche de mise à la terre est utilisée pour mettre à la terre les piliers d'isolation métalliques.

15. Construction d'antenne en boîtier qui est configurée pour transmettre un signal de liaison montante et pour recevoir un signal de liaison descendante qui ont des bandes de fréquences différentes, comprenant :

une couche de puce (10) comprenant au moins une puce de transmission (11) et au moins une puce de réception (13) ;

une première couche diélectrique (21) sur la couche de puce, dans laquelle le premier diélectrique a une constante diélectrique qui est supérieure à 3,5 ;

une seconde couche diélectrique (23) entre la couche de puce et la première couche diélectrique ;

une antenne réseau de transmission (31) comprenant une pluralité de premières antennes (311), connectées électriquement à la puce de transmission et s'étendant de la puce de transmission à la seconde couche diélectrique, dans laquelle chacune des premières antennes est espacée d'une première distance d'une antenne adjacente des premières antennes, et la première distance est proche d'une demi-longueur d'onde ;

une antenne réseau de réception (33) comprenant une pluralité de secondes antennes (333), connectées électriquement à la puce de réception et s'étendant de la puce de réception à la première couche diélectrique, dans laquelle l'antenne réseau de transmission (31) et l'antenne réseau de réception (33) sont agencées dans une séquence entrelacée alternée, et chacune des secondes antennes est espacée d'une seconde distance d'une antenne adjacente des secondes antennes, et la seconde distance est proche de la demi-longueur d'onde et est différente de la première distance ; et

une pluralité de piliers d'isolation métalliques (41) entourant chacune des premières antennes et chacune des secondes antennes.

FIG. 1

FIG. 2

EP 4 507 120 B1

20

10

EP 4 507 120 B1

FIG. 3

FIG. 4

EP 4 507 120 B1

FIG. 5A

EP 4 507 120 B1

$$35 \begin{cases} 351 \\ 353 \\ 354 \end{cases} \qquad 36 \begin{cases} 361 \\ 363 \\ 364 \end{cases}$$

FIG. 5B

FIG. 5C

FIG. 5D

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200035625 A1
- US 11217543 B2
- US 10505255 B2
- US 2020185299 A1
- TW M637071 U